# EUROPEAN PATENT SPECIFICATION

(11) **EP 3 926 661 B1**
(45) Date of publication and mention of the grant of the patent: **12.02.2025**
(21) Application number: 20179998.8
(22) Date of filing: 15.06.2020
(51) Int. Cl.: H01L 21/306, H01L 27/146

(54) **METHOD OF THINNING A SEMICONDUCTOR SUBSTRATE TO HIGH EVENNESS AND SEMICONDUCTOR SUBSTRATE HAVING A DEVICE LAYER OF HIGH EVENNESS**
VERFAHREN ZUM DÜNNEN EINES HALBLEITERSUBSTRATS MIT HOHER EBENHEIT UND HALBLEITERSUBSTRAT MIT EINER VORRICHTUNGSSCHICHT MIT HOHER EBENHEIT
PROCÉDÉ D'AMINCISSEMENT D'UN SUBSTRAT SEMICONDUCTEUR À UNIFORMITÉ ÉLEVÉE ET SUBSTRAT SEMICONDUCTEUR DOTÉ D'UNE COUCHE DE DISPOSITIF D'UNIFORMITÉ ÉLEVÉE

(43) Date of publication of application: 22.12.2021
(73) Proprietor: Infineon Technologies AG, 85579 Neubiberg (DE)
(72) Inventor: FREY, Alexander, 93138 Lappersdorf (DE); MODER, Iris, 9500 Villach (AT); SIGL, Alfred, 93161 Sinzing (DE); GOLLER, Bernhard, 9500 Villach (AT); WEINDLER, Tobias, 93158 Teublitz (DE); MURI, Ingo, 9500 Villach (AT)
(74) Representative: Lambsdorff & Lange Patentanwälte Partnerschaft mbB

(56) References cited:
- US-A1- 2018 350 660
- US-A1- 2020 058 746
- US-B1- 10 395 974

## Description

### Technical Field

This disclosure relates generally to the field of manufacturing semiconductor devices, and in particular to the field of thinning a semiconductor substrate to high evenness.

### Background

Various semiconductor devices such as, e.g., backside-illuminated (BSI) image sensors require a thin crystalline semiconductor layer with a low total thickness variation (TTV).

Conventionally, thin crystalline silicon layers with low TTVs are manufactured by processes including grinding and dopant selective chemical etching of a semiconductor substrate, e.g. a wafer.

While grinding offers high removal rates of semiconductor material, the TTV after the grinding process is too high for many devices such as, e.g., BSI image sensors. On the other hand, dopant selective chemical etching allows achieving thin crystalline semiconductor layers with small TTVs. However, dopant selective chemical etching requires the thin crystalline semiconductor layer (device layer) to have a low doping density (e.g. less than 10¹⁷ cm⁻³) to be resistant to the chemical etchant used in the process. This prevents this method from being used for manufacturing devices having high doping densities in at least parts thereof in order to achieve a high device performance.

For instance, certain 3D image sensors require a high doping density in at least parts thereof to achieve good demodulation contrast and depth resolution. The low doping density constraint of the device layer when subjected to dopant selective chemical etching prevents such sensors from being fabricated in BSI geometry. This, in turn, limits the possibility to shrink the pixel size of such image sensors to achieve higher image resolution.

An additional challenge for BSI technology is the alignment of lithography processes done on the wafer backside after bonding and thinning to features defined on the front side before the device layer is manufactured. US 2020/0058746 A1 describes a method of fabricating a semiconductor-on-insulator SOI substrate including a thin device layer of high evenness. The device layer was formed by etching a sacrificial substrate down to an etch stop layer, removing the etch stop layer and cyclically thinning the device layer. US 10,395,974 B1 describes a method of fabricating a SOI substrate including a thin device layer of high evenness. The device layer was formed by etching a sacrificial substrate down to an etch stop layer and by removing the etch stop layer using an etchant comprising hydrofluoric acid, hydrogen peroxide, and acetic acid. US 2018/0350660 A1 describes a method of fabricating a semiconductor substrate including a device layer. The semiconductor substrate includes a III-V GaN etch stop layer on a surface of the device layer.

### Summary

According to an aspect of the disclosure, a method of manufacturing a semiconductor device is described. The method comprises providing a semiconductor substrate. The semiconductor substrate comprises a high-doped semiconductor substrate layer having a doping density which is in a range between 1×10¹⁸ cm⁻³ to 5×10²⁰ cm⁻³, a high-doped semiconductor device layer, and a low-doped semiconductor etch stop layer of silicon arranged between the high-doped semiconductor substrate layer and the high-doped semiconductor device layer. A doping density of the high-doped semiconductor device layer is equal to or greater than 10¹⁷ cm⁻³, or 10¹⁸ cm⁻³, or 5×10¹⁸ cm⁻³. A doping density of the low-doped semiconductor etch stop layer is less than 10¹⁷ cm⁻³, or 10¹⁶ cm⁻³, or 10¹⁵ cm⁻³ . The low-doped semiconductor etch stop layer has a thickness between 1 um and 12 um. The low-doped semiconductor etch stop layer borders the high-doped semiconductor device layer. The high-doped semiconductor substrate layer is removed, wherein the removing comprises dopant selective chemical etching stopping at the low-doped semiconductor etch stop layer. Further, the low-doped semiconductor etch stop layer is thinned to generate an exposed surface of the high-doped semiconductor device layer.

According to another aspect of the disclosure, a semiconductor wafer comprises a low-doped semiconductor device layer, a high-doped semiconductor device layer arranged over the low-doped semiconductor device layer, and a low-doped semiconductor etch stop layer of silicon arranged over the high-doped semiconductor device layer. A doping density of the high-doped semiconductor device layer is equal to or greater than 10¹⁷ cm⁻³, or 10¹⁸ cm⁻³, or 5×10¹⁸ cm⁻³. A doping density of the low-doped semiconductor etch stop layer is less than 10¹⁷ cm⁻³, or 10¹⁶ cm⁻³, or 10¹⁵ cm⁻³. The low-doped semiconductor etch stop layer borders the high-doped semiconductor device layer. The low-doped semiconductor etch stop layer has a thickness between 1 um and 12 um, an exposed etch stop surface and a total thickness variation, TTV, of equal to or less than 1.0 um.

### Brief description of the drawings

The elements of the drawings are not necessarily to scale relative to each other. Like reference numerals designate corresponding similar parts. The features of the various illustrated embodiments can be combined unless they exclude each other and/or can be selectively omitted if not described to be necessarily required. Embodiments are depicted in the drawings and are exemplarily detailed in the description which follows.
Figure 1 is a schematic cross-sectional view of an exemplary carrier substrate and an exemplary device substrate at a stage of manufacturing a semiconductor device.
Figure 2 is a schematic cross-sectional view of the exemplary carrier substrate and the exemplary device substrate of Figure 1 at a manufacturing stage after substrate bonding.
Figure 3 is a schematic cross-sectional view of the exemplary structure of Figure 2 at a manufacturing stage after partial removal of a high-doped semiconductor substrate layer of the exemplary device substrate.
Figure 4 is a schematic cross-sectional view of the exemplary structure of Figure 3 at a manufacturing stage after complete removal of the high-doped semiconductor substrate layer of the exemplary device substrate.
Figure 5 is a schematic cross-sectional view of the exemplary structure of Figure 4 at a manufacturing stage after removal of a low-doped semiconductor etch stop layer of the exemplary device substrate.
Figure 6 is a flowchart depicting stages of an exemplary method of manufacturing a semiconductor device in accordance with aspects of the disclosure.
Figure 7 is a schematic cross-sectional view of an exemplary semiconductor device manufactured in accordance with aspects of the disclosure.
Figures 8A-8P are schematic cross-sectional views illustrating exemplary stages of a process flow to manufacture a semiconductor device in accordance with aspects of the disclosure.
Figures 9A and 9B are diagrams illustrating the dependency of the doping concentration from the depth as obtained by simulation (Figure 9A) and by measurement (Figure 9B).
Figures 10A and 10B are diagrams illustrating the dependency of the doping concentration from the depth for a BSI image sensor in accordance with aspects of the disclosure (Figure 10A) and for a conventional BSI image sensor (Figure 10A) after layer deposition.
Figures 11A and 11B are diagrams illustrating the dependency of the doping concentration from the depth for a BSI image sensor in accordance with aspects of the disclosure after thinning the low-doped semiconductor etch stop layer (Figure 11A) and for a conventional BSI image sensor after removing the high-doped semiconductor substrate layer (Figure 11B).
Figures 12A and 12B are diagrams illustrating the dependency of the doping concentration from the depth for a BSI image sensor in accordance with aspects of the disclosure without counter-doping in the low-doped semiconductor etch stop layer (Figure 12A) and with counter-doping in the low-doped semiconductor etch stop layer (Figure 12B).
Figure 13 is an illustration showing an exemplary measured layer thickness at different stages of thinning before and after chemical mechanical polishing (CMP).
Figure 14 is an illustration showing an exemplary semiconductor device with a high doping concentration at the surface and a low TTV.
Figures 15A-15C are schematic cross-sectional views of an exemplary semiconductor device in accordance with aspects of the disclosure illustrating patterning the low-doped semiconductor etch stop layer to produce visible alignment marks.

### Detailed description

It is to be understood that the features of the various exemplary embodiments and examples described herein may be combined with each other, unless specifically noted otherwise.

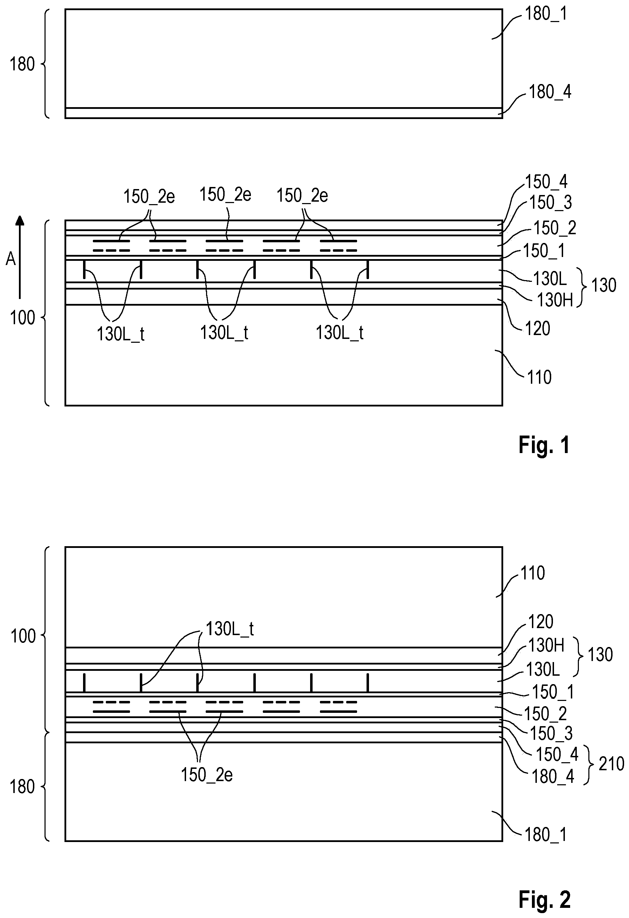

Referring to Figure 1, a device semiconductor substrate 100 includes a high-doped semiconductor substrate layer 110, a high-doped semiconductor device layer 130H and a low-doped semiconductor etch stop layer 120, referred to as substrate 100, substrate layer 110, device layer 130H and etch stop layer 120 respectively hereinafter. The etch stop layer 120 is arranged between the substrate layer 110 and the device layer 130H.

The substrate 100 may, e.g., be a semiconductor wafer. The substrate 100 may be made of any semiconductor material, e.g., Si, SiC, SiGe, GaAs, GaN, AlGaN, InGaAs, InAlAs, etc. Without loss of generality, the following description relates to a substrate 100 which is a silicon wafer.

The substrate layer 110 has a doping density which is in a range between 1×10¹⁸ cm⁻³ to 5×10²⁰ cm⁻³, in particular 3×10¹⁸ cm⁻³ to 3×10¹⁹ cm⁻³ or e.g. 4-6×10¹⁸ cm⁻³. The substrate layer 110 may be doped with boron, arsenic or phosphorus. In some applications arsenic may be advantageous as a dopant since it diffuses less and sharper doping profiles can be obtained. The substrate layer 110 may, e.g., have a thickness between about 600 µm and 1000 um. In the example shown in Figure 1, the thickness may, e.g., be 720 µm.

The doping density of the low-doped semiconductor etch stop layer 120 is less than 10¹⁷ cm⁻³, or 10¹⁶ cm⁻³, or 10¹⁵ cm⁻³. The low-doped semiconductor etch stop layer 120 may be an epitaxial layer. It has a layer thickness of 1-12 um, in particular 2-6 um. The dopant type may, e.g., be of no relevance.

The doping density of the device layer 130H is equal to or greater than 10¹⁷ cm⁻³, or 10¹⁸ cm⁻³, or 5×10¹⁸ cm⁻³. The device layer 130H may be doped with boron, arsenic, phosphorus, or antinomy. Generally, the dopant of the device layer 130H may be the same as the dopant of the substrate layer 110 or a different one. Further, the device layer 130H may have different doping levels and/or materials in different depths or different areas of the device layer 130H, i.e. may be structured in terms of doping levels and/or doping materials and/or doping depths and/or doping areas.

The substrate 100 may further include a low-doped semiconductor device layer 130L. Hence, a device layer 130 of the semiconductor substrate 100 may include solely the device layer 130H or the device layer 130H and the low-doped semiconductor device layer 130L as depicted in Figure 1.

In the latter case, the device layer 130H may, e.g., be a high-doped p-buried layer implant introduced into the low-doped semiconductor device layer 130L. More specifically, the device layer 130H may be fabricated by implanting a dopant such as, e.g., boron (implant energy of e.g. 25 keV). The implant impurities (e.g. boron impurities) may then be activated by annealing (e.g. at 1050°C). Implant damages of the low-doped semiconductor device layer 130L may, e.g., be removed, for example by surface oxidation and wet chemical oxide removal.

An alternative method may be to grow the full layer stack comprising the etch stop layer 120 and the high-doped and low-doped device layers 130H, 130L by epitaxy in one or more runs with in-situ doping.

Further, the substrate 100 may comprise a functional layer stack 150. The design of the functional layer stack is dependent on the semiconductor device to be manufactured from the substrate 100. For example, the functional layer stack 150 may include one or more metal contact layers 150_2, insulating (e.g. SiO) layers 150_1, 150_3 encapsulating the metal contact layer(s) 150_2 and a wafer bonding (e.g. SiO) layer 150_4 for wafer bonding.

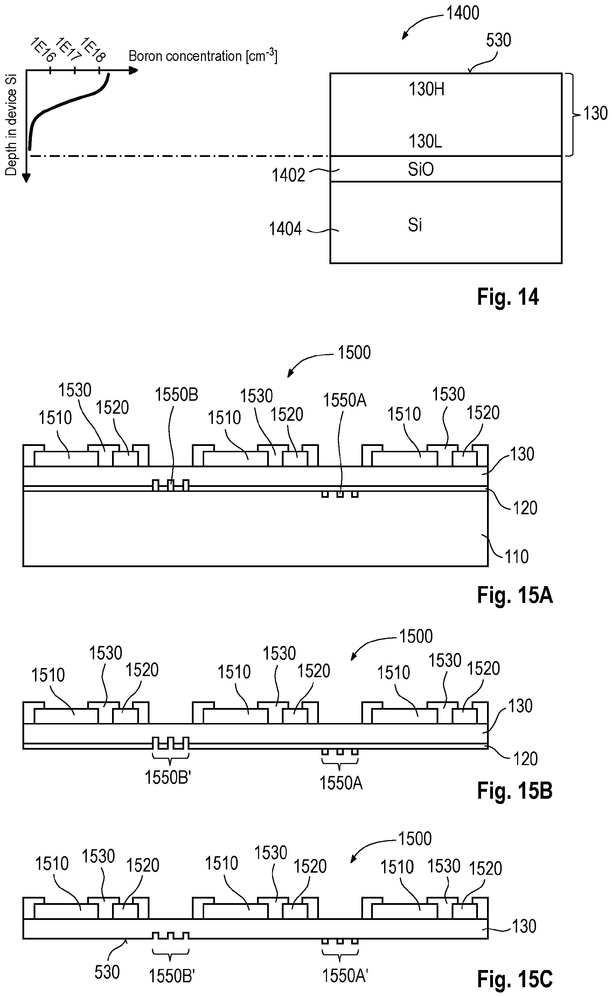

The device layer 130 (in particular the low-doped semiconductor device layer 130L) and the functional layer stack 150 may be structured depending on the semiconductor device to be manufactured from the substrate 100. In Figure 1, by way of example, the low-doped semiconductor device layer 130L is structured by (optional) insulation trenches 130L_t. The metal contact layer(s) 150_2 are structured by groups of metal electrodes 150_2e. As will be described in more detail further below, the groups of metal electrodes 150_2e together with the insulating trenches 130L_t form pixels of a BSI image sensor used here as an example of a semiconductor device in accordance with the disclosure. In other embodiments the functional layer stack 150 may include other semiconductor devices such as, e.g., power semiconductor chips (see e.g. Figures 15A-15C).

Substrate 100 may be formed by complementary metal-oxide-semiconductor (CMOS) technology. The growth direction of the various layers 120, 130H, 130L, 150 atop the substrate layer 110 is indicated by arrow A.

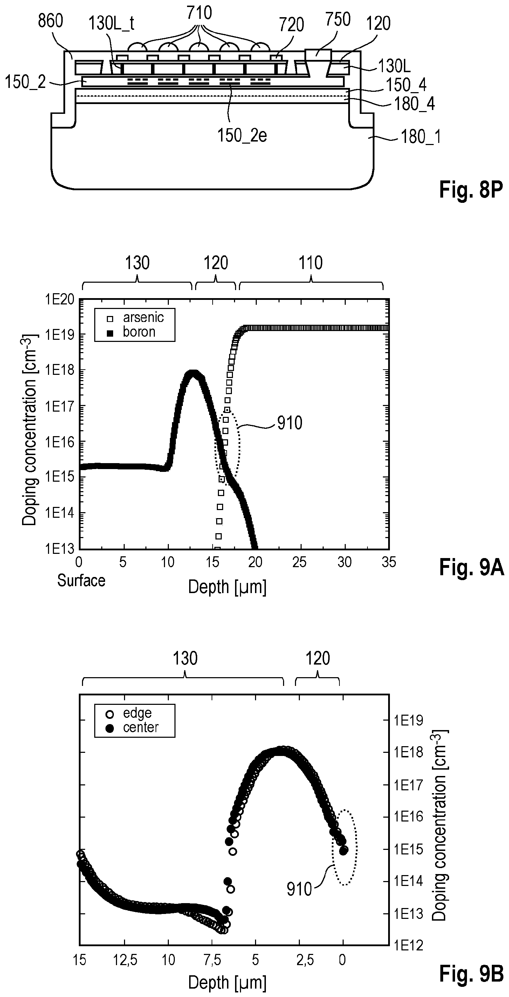

As mentioned before, the low-doped semiconductor device layer 130L (in which the device layer 130H has been implanted) may be designed in various different ways in accordance with the characteristics and functionality of the semiconductor device to be manufactured. In the example described herein, the low-doped semiconductor device layer 130L may have been formed by Si epitaxy, may, e.g., have a thickness of about 3-20 um, in particular 10-13 um (which has been found to be preferable for high-performance time-of-flight (ToF) image sensors). Further, optionally desired doping profiles are generated in the low-doped semiconductor device layer 130L. For example, this may include creating a doping profile in epitaxy or by thermally induced interdiffusion from the buried device layer 130H into the epitaxial low-doped semiconductor device layer 130L. An exemplary doping profile of the (buried) device layer 130H in the low-doped semiconductor device layer 130L will be explained in more detail further below in conjunction with Figures 9A and 9B.

The low-doped semiconductor device layer 130L and the semiconductor device layer 130H may have a total thickness of equal to or less than 15 um, or 10 um, or 5 um, or 3 um, or 2 um. However, it is also possible that the device layer 130H is (much) thicker, e.g. has a thickness of equal to or greater than 50 um or 100 µm.

The optional insulating trenches 130L_t may be formed to create optically and/or electrically isolated pixels in the low-doped semiconductor device layer 130L. Further, as mentioned above, the formation of groups of metal electrodes 150_2e, e.g. metal contacts and gates, may define a matrix of pixels on the low-doped semiconductor device layer 130L.

The wafer bonding layer 150_4 may be formed by silicon oxide deposition and polishing. The wafer bonding layer 150_4 may have a thickness between, e.g., 50 to 200 nm and may, e.g., create an atomically smooth (e.g. having an unevenness of below 0.5 nm root mean square (RMS)) oxide surface layer.

Further, a carrier semiconductor substrate 180 may be provided. The carrier semiconductor substrate 180 may be a semiconductor wafer, e.g. a silicon wafer. The carrier semiconductor substrate 180 may comprise a carrier substrate layer 180_1 and a wafer bonding layer 180_4. The carrier substrate layer 180_1 may have a thickness in the same range as the thickness of the substrate layer 110, in this example, e.g., a thickness of 720 um. The carrier semiconductor substrate 180 may (also) contain integrated circuits (ICs - not shown) and/or one or more metal wiring layer(s) (not shown) to interconnect the ICs either to integrated circuitry (e.g. specific pixels) on the substrate 100 or to electrodes or die pads (not shown) on the carrier semiconductor substrate 180 used as external terminals.

The wafer bonding layer 180_4 may, e.g., be a SiO layer having a layer thickness in a range between 1-200 nm. The wafer bonding layer 180_4 may be atomically smooth (e.g. having an unevenness below 0.5 nm RMS).

The carrier semiconductor substrate 180 may be used in a manufacturing process for devices featuring BSI geometry, e.g. for BSI image sensors, in particular for ToF image sensors employing BSI technology.

Referring to Figure 2, the substrate (e.g. device wafer) 100 and the carrier semiconductor substrate (e.g. carrier wafer) 180 are then bonded together with their respective front sides. Voids and particles in the bond interface 210 formed by the wafer bonding layers 150_4 and 180_4 should be avoided. Annealing may be used to make the bond stable and durable.

If the carrier semiconductor substrate 180 contains for instance ICs to be connected to specific integrated circuitry (e.g. specific pixels) on the substrate 100, the bond between the substrate 100 and the carrier semiconductor substrate 180 should be generated with high spatial accuracy, preferably equal to or less than 200 nm or 150 nm. Figure 2 illustrates an intermediate stage of fabrication after semiconductor substrate bonding (e.g. wafer bonding) and flipping the bonded device.

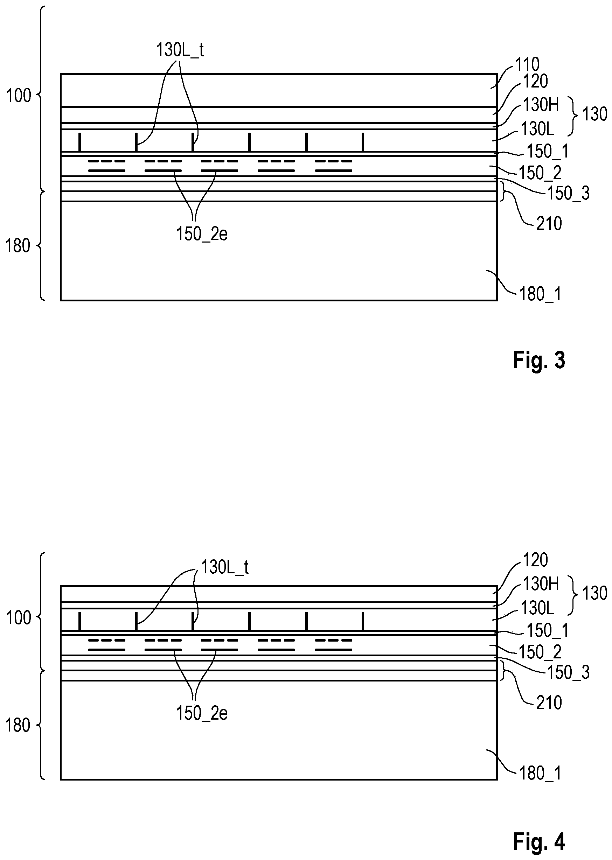

Referring to Figure 3, the substrate layer 110 of the substrate 100 is then partially removed by, e.g., grinding. A thickness of, e.g., 600-1000 um of the substrate layer 110 may be removed. The partial removal may stop at about 5-50 um, in particular 5-15 um, of the substrate layer 110 for subsequent wet chemical removal, as will be explained in more detail in conjunction with Figure 4. The TTV after the partial removal (e.g. grinding) process may, for example, be 2-3 µm on, e.g., a 200 mm wafer, which is too high for some devices, e.g. for image sensor products.

Referring to Figure 4, the substrate layer 110 may then be completely removed by dopant selective chemical etching until the etch stop layer 120 is reached. The removal by dopant selective chemical etching may remove a thickness between 5-50 um, in particular 5-15 um or 5-10 um, of the remainder of the substrate layer 110. For the dopant selective chemical etching process, a dopant selective wet chemical solution may be used, which will etch the remainder of the substrate layer 110 quickly at, e.g., a rate of 10-50 pm/min. The dopant selective chemical etching process will hold at the etch stop layer 120 before reaching the device layer 130H.

More specifically, a dopant selective etchant such as, e.g., HNA may be used. This is a mixture of hydrofluoric acid (HF), nitric acid (HNO₃), acetic acid (CH₃COOH) and water. A typical concentration may be HF at 10 wt%, HNO₃ at 20 wt%, and CH₃COOH at 50wt%. The HNA mixture etches high-doped silicon quickly, e.g. with an etch rate of 20-40 um/min. Low-doped materials are etched very slowly, e.g. at a rate of 0.2 pm/min. Thereby, the etchant removes the highly doped substrate and with it all roughness and on-substrate inhomogeneity brought in by the initial rough grinding process. The dopant selective chemical etching stops "inside" the etch stop layer 120 where the doping density falls below a certain limit (as described in more detail further below in conjunction with Figures 9A, 9B).

The TTV of the remaining semiconductor layers on top of the carrier semiconductor substrate 180 (i.e. of the layers of the substrate 100 at the intermediate stage of fabrication shown in Figure 4) may, e.g., be between 0.1 and 1.0 µm on, e.g. a 200 mm wafer. It is much lower than the TTV of the remaining semiconductor layers on top of the carrier semiconductor substrate 180 at the intermediate stage of fabrication shown in Figure 3, and is thus suitable for, e.g., image sensor products. More specifically, referring to Figure 4, a TTV of e.g. 0.78 um was achieved, which is sufficient and can be further improved by improving the homogeneity of the epitaxial layer thickness of the etch stop layer 120 and the low-doped semiconductor device layer 130L.

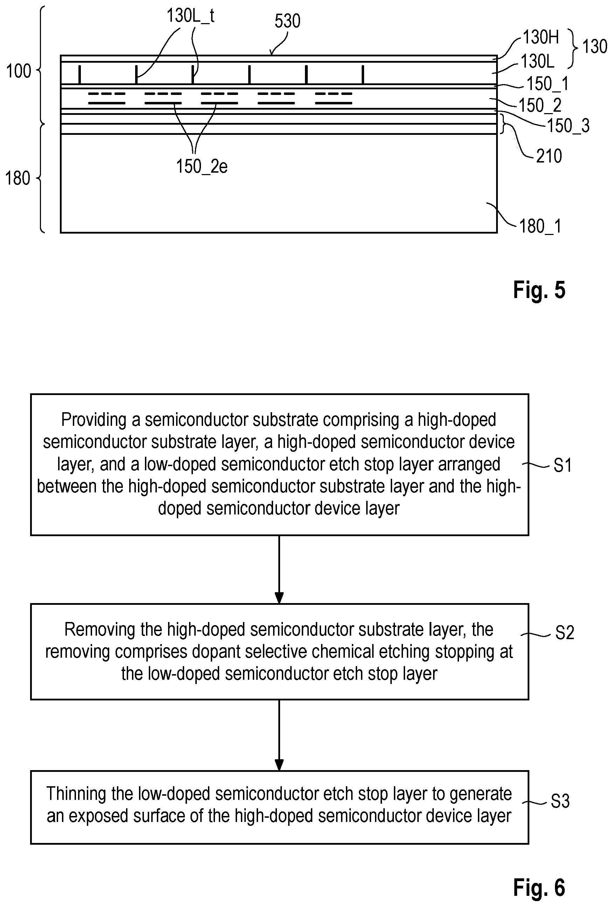

Referring to Figure 5, the etch stop layer 120 is then removed to expose the device layer 130H. An exposed surface of the device layer 130H is denoted by reference sign 530. The device layer 130H may then have a low TTV since inhomogeneities from the grinding process (Figure 3) are neutralized by the etch stop layer 120. At the same time the device layer 130H can be highly doped since it does not come in contact with a dopant selective etch chemistry.

The etch stop layer 120 should be thick enough to provide a reliable barrier for the dopant selective wet chemical etching solution to protect the device layer 130H. Dopant inter-diffusion from the substrate layer 110 and from the device layer 130H may reduce its effective thickness, especially when high temperature processes at temperatures equal to or greater than, e.g., 1000°C are applied to the substrate (device wafer) 100 and the carrier semiconductor substrate (carrier wafer) 180.

On the other hand, the etch stop layer 120 should not be too thick since then the additional thickness variations caused during its removal (see Figure 5) would be too high to achieve the target of having a low TTV of, e.g., equal to or less than 1 um after the removal of the etch stop layer 120. The thickness of the etch stop layer 120 is selected to be between 1 um and 12 um, wherein a thickness of 6 µm ± 3 µm (or ± 2 um, or ± 1 um, or ± 0 um) has shown to be a good compromise for both challenges mentioned above.

Differently put, the provision of the etch stop layer 120 allows for implementing a device layer 130H (as it is desired for device performance) and the small thickness of the etch stop layer 120 allows to preserve the small initial TTV at the onset of thinning throughout the thinning process until it ends at the exposed surface 530 of the device layer 130H.

The optimum thickness of the etch stop layer 120 may also depend on the type of dopant. The etch stop layer 120 may be made thinner (e.g. thinner than 6 um) if heavy dopant atoms such as arsenic are used in the substrate layer 110 and/or in the device layer 130H. Those dopants show less inter-diffusion into the etch stop layer 120 during high temperature processing, resulting in that the effective thickness of the etch stop layer 120 is reduced by inter-diffusion to a lesser extent (and therefore the actual thickness can be designed smaller).

The removal of the etch stop layer 120 may be carried out by chemical etching or by chemical mechanical polishing (CMP). Chemical etching may be carried out by a wet chemical etching process or a dry chemical etching process.

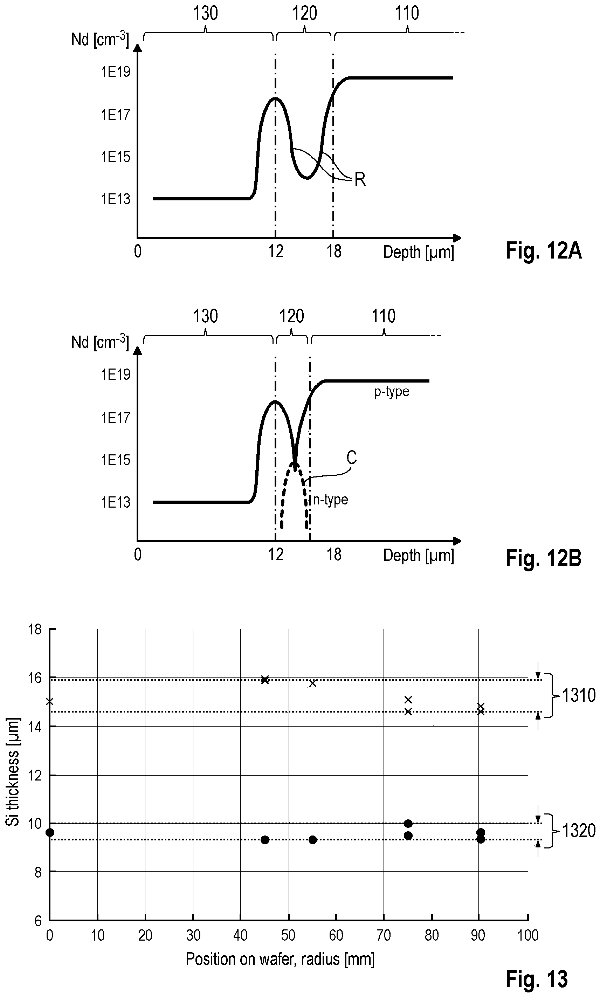

CMP may be the preferred method since the CMP process has more degrees of freedom that can be controlled than the wet or dry chemical etching process (where additional unevenness may be caused by different etching rates). Using CMP the removal rate can be tuned to achieve a minimum total thickness variation across the wafer. For example, if the remaining etch stop layer 120 is typically thinner at the edge of the substrate (wafer) than in the middle of the substrate (wafer), which might be due to higher etch rates in the preceding steps due to heating of the etchant towards the substrate (wafer) edge, then the CMP removal rate can be reduced at the substrate (wafer) edge to compensate this thickness variation. An example of such improvement of TTV by CMP will be described further below in conjunction with Figure 13.

The total amount of material to be removed in one run is limited to < 6um, preferably < 3um. Also for this reason, it is desirable to have the etch stop layer 120 as thin as possible. This, however, opposes the requirement for a robust etch stop process without runaway etching as well as inter-diffusion of dopants from the neighboring substrate layer 110 and device layer 130H. To enable a thinner etch stop layer 120, while at the same time maintaining a robust etch stopping behavior in presence of inter-diffusing dopants from the device layer 130H, the etch stop layer 120 may be counter-doped with a material of opposing dopant polarity, as will be described in more detail further below in conjunction with Figure 12B.

Referring to Figure 6, at S1 a semiconductor substrate is provided comprising a substrate layer, a device layer and a etch stop layer arranged between the substrate layer and the device layer. As mentioned above, the etch stop layer has a thickness between 1 um and 12 um.

At S2 the substrate layer is removed. The removing comprises dopant selective chemical etching which stops at the etch stop layer. An exemplary intermediate stage of fabrication obtained by S2 is illustrated in Figure 4.

At S3 the etch stop layer is thinned to generate an exposed surface of the device layer. A stage of fabrication which may be obtained after carrying out S3 is illustrated in Figure 5.

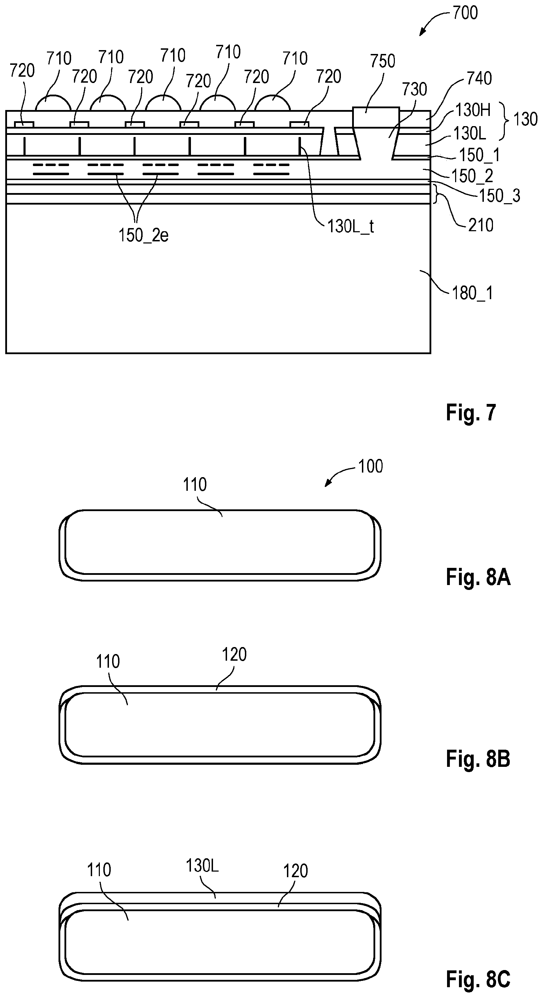

Figure 7 illustrates a simplified final ToF image sensor device as an example of a semiconductor device 700 manufactured in accordance with aspects of the disclosure. The semiconductor device 700 may include micro-lenses 710, a metal grid 720, a through semiconductor via 730 and an insulating layer 740. The through semiconductor via 730 may be configured to electrically contact the buried metal contact layer(s) 150_2 beneath the low-doped semiconductor device layer 130L and the device layer 130H. The micro-lenses 710 may be fabricated on top of the pixel array and the metal grid 720 may be arranged to direct or shield incident light from certain parts of the pixels (as defined by the insulating trenches 130L_t and the groups of metal electrodes 150_2e). Electrode pads 750 (e.g. made of Al or Cu) may be placed on the through semiconductor vias 730.

Finally, the semiconductor device 700 is tested, diced and placed in an adequate package which allows infrared light to reach the pixel array surface. To achieve ToF 3D imaging this package may be assembled in a system which includes an infrared light source such as laser diode to emit light in a temporarily modulated or pulsed way. The ToF of the reflections of these light pulses of a free-dimensional scene is then detected by the pixels of the semiconductor device 700, and a 3D rendering of the scene may be reconstructed.

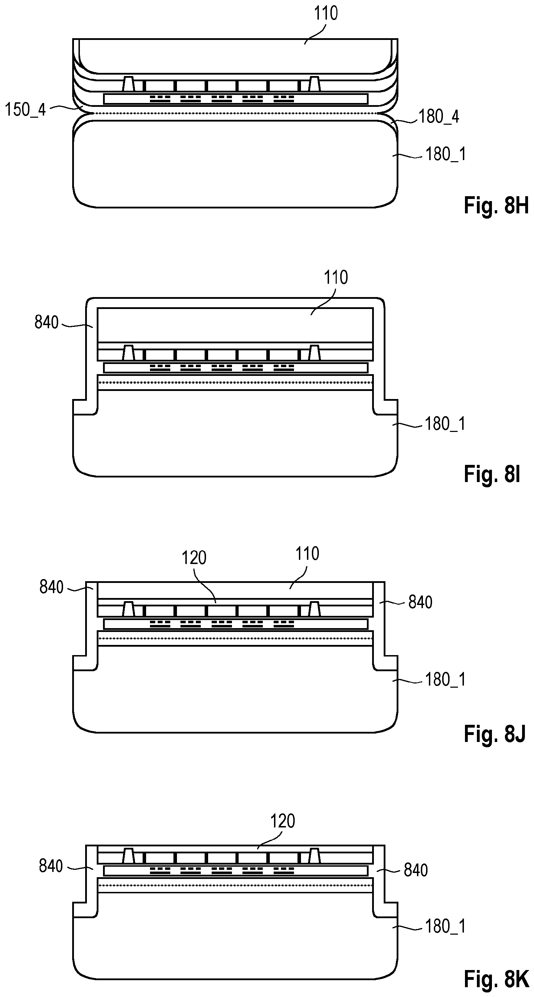

Figures 8A-8P illustrate an exemplary process flow to manufacture a semiconductor device in accordance with aspects of the disclosure. The exemplary stages illustrated in Figures 8A-8P can selectively be combined with manufacturing stages described above and vice versa. In particular, the process flow shown in Figures 8A-8P illustrates trimming of the wafer edge during grinding to reduce unwanted particle density due to chipping at the wafer edge and/or a deposition of an edge protection layer which protects the device layers 130L, 130H especially during wet etching (see Figure 8I). Both these processes (trimming of the wafer edge and/or depositing of an edge protection layer) are generally available and not bound to the specific process flow of Figures 8A-8P.

Figure 8A illustrates a device wafer 100 having the substrate layer 110. This high-doped semiconductor wafer may be a 200 mm Si high-doped backside epitaxial sealing wafer.

In Figure 8B, the etch stop layer 120 is generated. The etch stop layer 120 may be an epitaxial layer of a thickness of 1-12 µm.

In Figure 8C the low-doped semiconductor device layer 130L (e.g. boron, doping density of 7.6×10¹⁴ cm⁻³, thickness of 12 um Si) may be generated as an epitaxial layer. Then, the device layer 130H may be formed as a buried implant layer (e.g. p-buried implant layer).

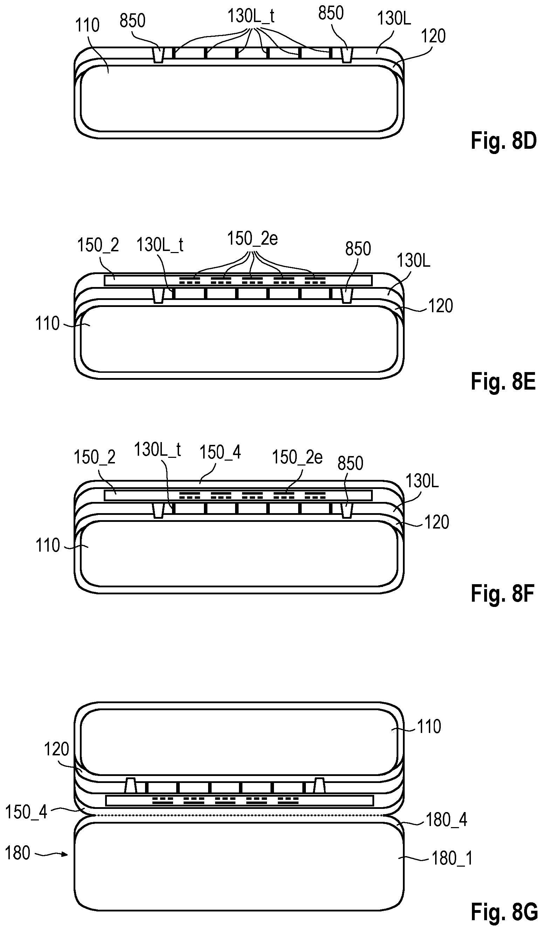

In Figure 8D the deep trench isolation (i.e. insulating trenches 130L_t) may be generated. Further, zero layer deep trenches 850 may be produced.

In Figure 8E the ToF metal contact layers 150_2 are applied.

In Figure 8F the wafer bonding layer 150_4 is applied by, e.g., using an oxide formation and a CMP process.

In Figure 8G the processed device wafer of Figure 8F is wafer bonded to a carrier wafer 180 by, e.g., silicon direct bonding (SDB) and/or silicon fusion bonding (SFB).

Figures 8H-8J illustrate an exemplary two-stage grinding process and an edge trimming and protection step carried out between the two grinding stages. More specifically, in Figure 8H a first stage grinding is performed to a target thickness of, e.g., 150 um of the residual substrate layer 110. Then, in Figure 8I the wafer edges are trimmed (e.g. 1 mm wide) and a TEOS (tetraethyl orthosilicate) oxide 840 (or any other edge protection insulating material) is deposited by, e.g., plasma-enhanced chemical vapor deposition (PECVD).

In Figure 8J a second stage grinding is performed to a target thickness of, e.g., 25 µm of the substrate layer 110.

Figure 8K illustrates wet etching which stops on the etch stop layer 120. A cleaning of the surface of the etch stop layer 120 may follow. A TTV of about 500 nm may be obtained.

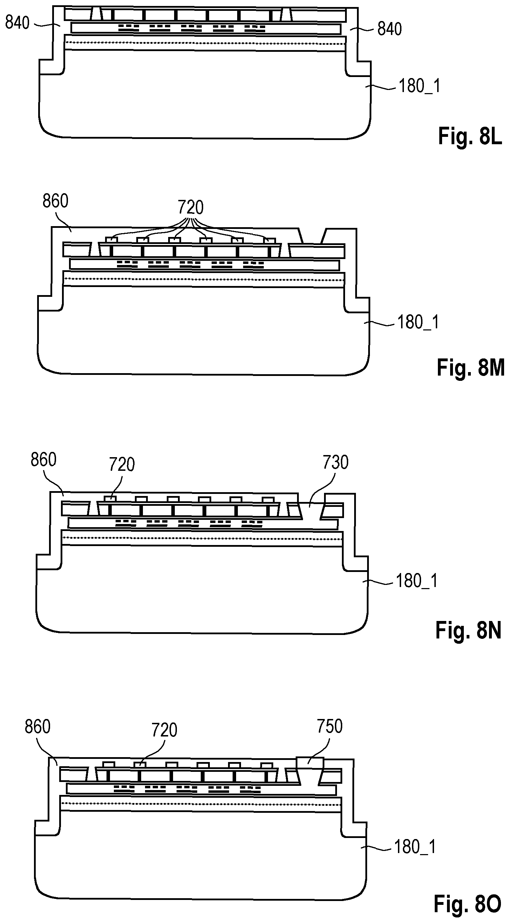

Figure 8L illustrates CMP of the etch stop layer 120. The TTV of 500 nm may substantially be preserved. Additionally, zero layer marks 850 may be revealed by this step so they are visible on the wafer surface in subsequent process steps.

Figures 8M-8P then illustrates process stages which are specifically used when a ToF BSI image sensor is fabricated. Briefly, in Figure 8M a tungsten grid 720 may be applied and a lithography mask 860 (e.g. SiO/SiN) may be applied for TSV (through silicon via) formation.

Figure 8N illustrates a TSV etch and a filling the etch hole with a metal, e.g. Cu.

In Figures 8O and 8P an electrode pad (e.g. Al pad) 750 is applied and the micro-lenses 710 are fabricated.

Figure 9A illustrates a simulated doping density profile in silicon of a wafer after forming the low-doped semiconductor (i.e. Si) etch stop layer 120 and the semiconductor (i.e. Si) device layers 130L, 130H on the high-doped semiconductor (i.e. Si) substrate layer 110 corresponding to the intermediate fabrication stage shown in Figure 1. The etch stop layer 120 is a Si epitaxial layer situated between the substrate layer 110 and the device layer 130H. Only semiconductor (i.e. Si) layers are shown, other materials such as SiO or metals are omitted. In this case, the substrate layer 110 is arsenic doped (n-type) and the device layers 130L and 130H are boron doped (p-type). This leads to a compensation of both dopants and thus to a low electrical carrier density in a certain range within the etch stop layer 120. By way of example, etching has been done for 40 s with an etch rate in the high-doped semiconductor (i.e. Si) device layer of about 40 pm/min.

Figure 9B illustrates the doping density profile measured by spreading resistance profiling (SRP) on a device Si substrate (wafer) 100 after removing the substrate layer 110 with dopant selective HNA wet etch corresponding to the intermediate fabrication stage shown in Figure 4. Hence, in Figure 9B the depth 0 corresponds to the surface of the low-doped Si etch stop layer 120. The encircled area 910 in Figure 9A corresponds to the encircled area 910 in Figure 9B.

By comparing the measured doping density profile of Figure 9B to the simulated doping density profile of Figure 9A it can be inferred that the doping density limit at which HNA etching stops is about 10¹⁷ cm⁻³. During etching, the temperature at the device Si substrate (wafer) surface has been monitored and it was observed that the temperature dropped from more than 30°C to about room temperature at a certain point in time and stayed low. This is consistent with the exothermal etching process stopping at a certain depth in the layer stack.

Further, Figure 9B shows that the doping density profile only slightly varies between the center of the substrate (wafer) 100 and its edge.

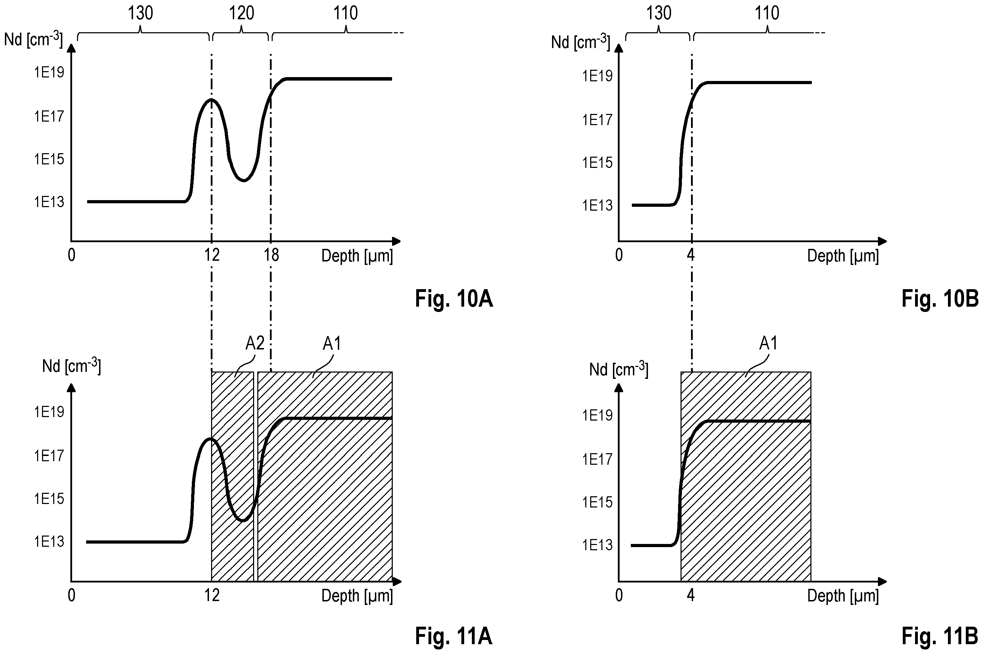

To illustrate the effect of a dedicated etch stop layer 120 for the thinning process for, e.g., BSI devices having a device layer 130H, doping profiles before and after thinning are shown in Figures 10A and 11A with a dedicated etch stop layer 120 and in Figures 10B and 11B without such dedicated etch stop layer 120.

In Figure 11A the hatched area A1 is removed in the first thinning step using dopant selective chemical etching while the hatched area A2 is removed in the second thinning stage using, e.g., non-selective dry or wet etching or CMP. In Figure 11B relating to BSI image sensor fabrication without using a etch stop layer 120, the hatched area A1 showing the first thinning step using dopant selective chemical etching is also depicted. The main difference between the BSI image sensor fabrication without (Figure 11B) and with (Figure 11A) using a etch stop layer 120 is that the device layer 130H is etched away by the HNA etchant in Figure 11B while in Figure 11A the etching stops clearly before reaching the device layer 130H. Hence, for a device, which should contain a high-doped layer at the surface, a dedicated etch stop layer 120 is needed.

Further, the layer thickness was measured after thinning with and without using a dedicated etch stop layer 120. If a dedicated etch stop layer 120 was used the TTV of the substrate 100 after thinning was equal to or less than 1 um (in this example, a TTV of 0.78 um was measured). If no dedicated etch stop layer 120 was used, a TTV of
2.11 um was measured.

Referring to Figure 10A, the rounded form R (indicated in Figure 12A) of the doping profile within the etch stop layer 120 is attributed to dopant inter-diffusion both from the substrate layer 110 and from the device layer 130H. The effect of counter-doping the etch stop layer 120 is illustrated by a comparison of Figure 12A (which corresponds to Figure 10A) and Figure 12B. Figure 12B shows a doping profile of an etch stop layer 120 with implanted n-type counter-doping of a doping density C. In case of a p-type (e.g. boron) doped semiconductor device layer 130L, 130H, the etch stop layer 120 may be n-type doped, e.g. with arsenic, phosphorus or antinomy. This counter-doping compensates the dopant inter-diffusion at R. If the doping density C of counter-doping is close to the doping density of inter-diffusing atoms, the resulting electrical carrier density in the inter-diffused region R of the etch stop layer 120 is reduced, and thus it will have a lower etch rate in, e.g., HNA.

Figure 13 illustrates a measured layer thickness at different stages of thinning, namely before CMP of the etch stop layer 120 at 1310 and after CMP of the etch stop layer 120 at 1320. As apparent from Figure 13, in this example the thickness of the substrate 100 is reduced by CMP from about 16 µm to about 10 µm (i.e. the etch stop layer 120 had a thickness of about 6 um). Figure 13 illustrates the improvement of TTV by the CMP process (which could not be achieved by chemical etching). The improvement can mainly be attributed to the tuning of the removal rate across the wafer radius when using CMP as the method of thinning the etch stop layer 120.

As mentioned earlier, some semiconductor devices as, e.g., BSI image sensors require a high doping density at least in parts of the device layer in order to achieve good device performance. An example of such doping profile required in those semiconductor devices is shown in Figure 14. As mentioned before, the TTV of the semiconductor device 1400 may be equal to or less than 1.0 um. In the example shown in Figure 14, the semiconductor device 1400 includes the device layer 130 having the device layer 130H and the low-doped semiconductor device layer 130L followed by an insulating layer 1402 (which may, e.g., correspond to the insulating layer 150_1) and by a semiconductor substrate layer 1404 implementing, e.g., ICs or other semiconductor device structures.

Figure 15A illustrates an exemplary semiconductor device 1500 before grinding and etching, i.e. at a stage of fabrication similar to that shown in Figure 1. Semiconductor device 1500 distinguishes from the semiconductor device shown in Figures 1 through 5 and 7 to 8 in that the semiconductor device 1500 implements power semiconductor transistors rather than an image sensor. More specifically, the semiconductor device 1500 may include a first electrode (e.g. source pad) 1510, a second electrode (e.g. gate pad) 1520 and an insulating layer (e.g. imide layer) 1530. Integrated circuitry such as, e.g., transistors, in particular power transistor, may be provided in the device layer 130 and electrically connected to the first and second electrodes 1510, 1520. Further, the semiconductor device 1500 includes the etch stop layer 120 and the substrate layer 110. In view of the device layer 130, the etch stop layer 120 and the substrate layer 110 reference is made to the description above in order to avoid reiteration. In particular, the device layer 130 may include exclusively a device layer 130H (which is structured to implement the transistors) or a combination of the device layer 130H and the low-doped semiconductor device layer 130L as described above.

Figure 15A further illustrates first type alignment features 1550A and second type alignment features 1550B. The first type alignment features 1550A may comprise low-doped regions protruding into the substrate layer 110. The second type alignment features 1550B may comprise high-doped regions protruding into the device layer 130.

The first type and second type alignment feature 1550A, 1550B may be generated by patterning the etch stop layer 120 to generate alignment features, which are configured to appear as visible alignment marks at a later stage of the fabrication of the semiconductor device 1500. More specifically, the first and second type alignment features 1550A, 1550B are configured to appear as visible alignment marks 1550A' and 1550B', respectively, in or on the exposed surface 530 of the device layer 130 after thinning.

Figure 15B illustrates the semiconductor device 1500 at a stage of fabrication after grinding and etching down to the etch stop layer 120. Hence, the fabrication stage of Figure 15B compares to the fabrication stage illustrated in Figure 4 for the example of an image sensor. Again, reference is made to the above description for the sake of brevity and in order to avoid reiteration.

Figure 15C illustrates a stage of fabrication of the semiconductor device 1500 which compares to the stage of fabrication shown in Figure 5, i.e. after the removal of the etch stop layer 120. At this stage of fabrication, the exposed surface 530 of the device layer 130 is laid bare. The alignment marks are preserved in the etch process removing the etch stop layer 120. More specifically, the first type alignment marks 1550A' (which are, e.g., structured from the etch stop layer 120) and the second type alignment marks 1550B' (which are, e.g., etched out of the device layer 130) are clearly visible thereon. Again, reference is made to the above description for the sake of brevity and in order to avoid reiteration.

The alignment marks 1550A' and 1550B' facilitate backside to front side alignment of lithographic processes. Differently put, the alignment marks 1550A' and 1550B' allow to better align lithographic processes done on the wafer backside after bonding and thinning to features defined on the front side before those steps. For example, returning to the BSI image sensor described above, the alignment marks 1550A' and/or 1550B', if similarly be formed on the exposed surface 530 of the device layer 130 (compare Figure 5), allow to carry out all steps after wafer bonding (compare Figure 8G-8P) with significantly higher accuracy and process reliability.

All characteristics, features and manufacturing variations explained above in conjunction with different embodiments can be selectively combined if not stated to the contrary or excluded by technical constraints. This applies in particular to the semiconductor transistor embodiment and the semiconductor image sensor embodiment described herein.

Although specific embodiments have been illustrated and described herein, this application is intended to cover any adaptations of the specific embodiments discussed herein. It is intended that these adaptations are foreseen as long as they fall within the scope afforded by the appended claims.

## Claims

1. A method of manufacturing a semiconductor device, the method comprising:
providing a semiconductor substrate (100) comprising
a high-doped semiconductor substrate layer (110) having a doping density which is equal to or greater than 1×10¹⁸ cm⁻³,
a high-doped semiconductor device layer (130H), wherein a doping density of the high-doped semiconductor device layer (130H) is equal to or greater than 10¹⁷ cm⁻³, or 10¹⁸ cm⁻³, or 5×10¹⁸ cm⁻³, and
a low-doped semiconductor etch stop layer (120) of silicon arranged between the high-doped semiconductor substrate layer (110) and the high-doped semiconductor device layer (130H), wherein a doping density of the low-doped semiconductor etch stop layer (120) is less than 10¹⁷ cm⁻³, or 10¹⁶ cm⁻³, or 10¹⁵ cm⁻³, the low-doped semiconductor etch stop layer (120) has a thickness between 1 µm and 12 µm and the low-doped semiconductor etch stop layer (120) borders the high-doped semiconductor device layer (130H);
removing the high-doped semiconductor substrate layer (110), the removing comprises dopant selective chemical etching stopping at the low-doped semiconductor etch stop layer (120); and
thinning the low-doped semiconductor etch stop layer (120) to generate an exposed surface of the high-doped semiconductor device layer (130H).

2. The method of claim 1, wherein thinning the low-doped semiconductor etch stop layer (120) comprises chemical mechanical polishing, CMP, or chemical etching.

3. The method of claim 1 or 2, wherein removing the high-doped semiconductor substrate layer (110) comprises
partially removing the high-doped semiconductor substrate layer (110) by grinding; followed by
completely removing the residual high-doped semiconductor substrate layer (110) by the dopant selective chemical etching.

4. The method of any of the preceding claims, wherein a total thickness variation, TTV, of the low-doped semiconductor etch stop layer (120) after removing the high-doped semiconductor substrate layer (110) is equal to or less than 1.0 um.

5. The method of any of the preceding claims, wherein the low-doped semiconductor etch stop layer (120) is an epitaxial layer.

6. The method of any of the preceding claims, wherein the low-doped semiconductor etch stop layer (120) is doped by a first dopant and counter-doped by a second dopant of opposite dopant polarity than the first dopant.

7. The method of any of the preceding claims, wherein a total thickness variation, TTV, of the high-doped semiconductor device layer after thinning the low-doped semiconductor etch stop layer (120) is equal to or less than 1.0 um.

8. The method of any of the preceding claims, wherein the high-doped semiconductor device layer (130H) is arranged on a low-doped semiconductor device layer (130L) and wherein the low-doped semiconductor device layer (130L) and the high-doped semiconductor device layer (130H) have a total thickness of equal to or less than 15 um, or 10 um, or 5 um, or 3 um, or 2 um.

9. The method of any of the preceding claims, further comprising:
patterning the low-doped semiconductor etch stop layer (120) to generate alignment features (1550A, 1550B) which are configured to appear as visible alignment marks (1550A', 1550B') in or on the exposed surface of the high-doped semiconductor device layer (130H) after thinning.

10. A semiconductor wafer, comprising:
a low-doped semiconductor device layer (130L),
a high-doped semiconductor device layer (130H) arranged over the low-doped semiconductor device layer (130L), wherein a doping density of the high-doped semiconductor device layer (130H) is equal to or greater than 10¹⁷ cm⁻³, or 10¹⁸ cm⁻³, or 5×10¹⁸ cm⁻³, and
a low-doped semiconductor etch stop layer (120) of silicon arranged over the high-doped semiconductor device layer (130H), wherein a doping density of the low-doped semiconductor etch stop layer (120) is less than 10¹⁷ cm⁻³, or 10¹⁶ cm⁻³, or 10¹⁵ cm⁻³, the low-doped semiconductor etch stop layer (120) borders the high-doped semiconductor device layer (130H), the low-doped semiconductor etch stop layer (120) has a thickness between 1 um and 12 um, an exposed surface and a total thickness variation, TTV, of equal to or less than 1.0 um.

11. The semiconductor wafer of claim 10, wherein the thickness of the high-doped semiconductor device layer (130H) is equal to or less than 15 um, or 10 um, or 5 um, or 3 um, or 2 µm as measured between a first surface of the high-doped semiconductor device layer (130H) bordering the low-doped semiconductor etch stop layer (120) and a second surface of the high-doped semiconductor device layer (130H) bordering the low-doped semiconductor device layer (130L).

12. The semiconductor wafer of any of claims 10 or 11, wherein the low-doped semiconductor etch stop layer (120) is doped by a first dopant and counter-doped by a second dopant of opposite dopant polarity than the first dopant.

13. The semiconductor wafer of any of claims 10 to 12, comprising a backside illuminated, BSI, image sensor device (1400) or a time-of-flight, ToF, image sensor device (700) or a power semiconductor device (1500).

## Patentansprüche

1. Verfahren zur Herstellung einer Halbleitervorrichtung, wobei das Verfahren aufweist:
Bereitstellen eines Halbleitersubstrats (100), das aufweist:
eine hochdotierte, Halbleitersubstratschicht (110) mit einer Dotierungsdichte, die gleich oder größer als 1·10¹⁸ cm⁻³ ist,
eine hochdotierte Halbleitervorrichtungsschicht (130H), wobei eine Dotierungsdichte der hochdotierten Halbleitervorrichtungsschicht (130H) gleich oder größer als 10¹⁷ cm⁻³, oder 10¹⁸ cm⁻³, oder 5×10¹⁸ cm⁻³ ist, und
eine niedrig dotierte Halbleiter-Ätzstoppschicht (120) aus Silizium, die zwischen der hoch dotierten Halbleitersubstratschicht (110) und der hoch dotierten Halbleitervorrichtungsschicht (130H) angeordnet ist, wobei eine Dotierungsdichte der niedrig dotierten Halbleiter-Ätzstoppschicht (120) weniger als 10¹⁷ cm⁻³ oder 10¹⁶ cm⁻³ oder 10¹⁵ cm⁻³, die niedrig dotierte Halbleiter-Ätzstoppschicht (120) eine Dicke zwischen 1 µm und 12 µm aufweist und die niedrig dotierte Halbleiter-Ätzstoppschicht (120) an die hoch dotierte Halbleitervorrichtungsschicht (130H) angrenzt;
Entfernen der hochdotierten Halbleitersubstratschicht (110), wobei das Entfernen ein dotierstoffselektives chemisches Ätzen aufweist, das an der niedrigdotierten Halbleiter-Ätzstoppschicht (120) stoppt; und
Dünnen der niedrigdotierten Halbleiter-Ätzstoppschicht (120), um eine freiliegende Oberfläche der hochdotierten Halbleitervorrichtungsschicht (130H) zu erzeugen.

2. Verfahren nach Anspruch 1, wobei das Dünnen der niedrig dotierten Halbleiter-Ätzstoppschicht (120) ein chemisch-mechanisches Polieren, CMP, oder ein chemisches Ätzen aufweist.

3. Verfahren nach Anspruch 1 oder 2, wobei das Entfernen der hoch dotierten Halbleitersubstratschicht (110) aufweist:
teilweises Entfernen der hoch dotierten Halbleitersubstratschicht (110) durch Schleifen; gefolgt von
vollständigem Entfernen der restlichen hochdotierten Halbleitersubstratschicht (110) durch das dotierstoffselektive chemische Ätzen.

4. Verfahren nach einem der vorhergehenden Ansprüche, wobei eine Gesamtdickenvariation TTV der niedrigdotierten Halbleiter-Ätzstoppschicht (120) nach dem Entfernen der hochdotierten Halbleitersubstratschicht (110) gleich oder kleiner als 1,0 µm ist.

5. Verfahren nach einem der vorhergehenden Ansprüche, wobei die niedrig dotierte Halbleiter-Ätzstoppschicht (120) eine Epitaxieschicht ist.

6. Verfahren nach einem der vorhergehenden Ansprüche, wobei die niedrig dotierte Halbleiter-Ätzstoppschicht (120) mit einem ersten Dotierstoff dotiert und mit einem zweiten Dotierstoff mit einer zum ersten Dotierstoff entgegengesetzten Dotierstoffpolarität gegendotiert wird.

7. Verfahren nach einem der vorhergehenden Ansprüche, wobei eine Gesamtdickenvariation TTV der hochdotierten Halbleitervorrichtungsschicht nach dem Dünnen der niedrigdotierten Halbleiter-Ätzstoppschicht (120) gleich oder weniger als 1,0 µm beträgt.

8. Verfahren nach einem der vorhergehenden Ansprüche, wobei die hochdotierte Halbleitervorrichtungsschicht (130H) auf einer niedrigdotierten Halbleitervorrichtungsschicht (130L) angeordnet ist und wobei die niedrigdotierte Halbleitervorrichtungsschicht (130L) und die hochdotierte Halbleitervorrichtungsschicht (130H) eine Gesamtdicke von gleich oder weniger als 15 µm, oder 10 µm, oder 5 µm, oder 3 µm, oder 2 µm aufweisen.

9. Verfahren nach einem der vorhergehenden Ansprüche, das ferner Folgendes aufweist:
Strukturieren der niedrig dotierten Halbleiter-Ätzstoppschicht (120), um Ausrichtungsmerkmale (1550A, 1550B) zu erzeugen, die so konfiguriert sind, dass sie nach dem Dünnen als sichtbare Ausrichtungsmarkierungen (1550A', 1550B') in oder auf der freiliegenden Oberfläche der hoch dotierten Halbleitervorrichtungsschicht (130H) erscheinen.

10. Halbleiterwafer, der Folgendes aufweist:
eine niedrig dotierte Halbleitervorrichtungsschicht (130L),
eine hochdotierte Halbleitervorrichtungsschicht (130H), die über der niedrigdotierten Halbleitervorrichtungsschicht (130L) angeordnet ist, wobei eine Dotierungsdichte der hochdotierten Halbleitervorrichtungsschicht (130H) gleich oder größer als 10¹⁷ cm⁻³ oder 10¹⁸ cm⁻³ oder 5×10¹⁸ cm⁻³ ist, und
eine niedrig dotierte Halbleiter-Ätzstoppschicht (120) aus Silizium, die über der hoch dotierten Halbleitervorrichtungsschicht (130H) angeordnet ist, wobei eine Dotierungsdichte der niedrig dotierten Halbleiter-Ätzstoppschicht (120) weniger als 10¹⁷ cm⁻³ oder 10¹⁶ cm⁻³ oder 10¹⁵ cm⁻³ beträgt, die niedrig dotierte Halbleiter-Ätzstoppschicht (120) an die hoch dotierte Halbleitervorrichtungsschicht (130H) angrenzt, die niedrig dotierte Halbleiter-Ätzstoppschicht (120) eine Dicke zwischen 1 µm und 12 µm, eine freiliegende Oberfläche und eine Gesamtdickenvariation TTV von gleich oder weniger als 1,0 µm aufweist.

11. Halbleiterwafer nach Anspruch 10, wobei die Dicke der hochdotierten Halbleitervorrichtungsschicht (130H) gleich oder weniger als 15 µm, 10 µm, 5 µm, 3 µm oder 2 µm beträgt, gemessen zwischen einer ersten Oberfläche der hochdotierten Halbleitervorrichtungsschicht (130H), die an die niedrigdotierte Halbleiter-Ätzstoppschicht (120) angrenzt, und einer zweiten Oberfläche der hochdotierten Halbleitervorrichtungsschicht (130H), die an die niedrigdotierte Halbleitervorrichtungsschicht (130L) angrenzt.

12. Halbleiterwafer nach einem der Ansprüche 10 oder 11, wobei die niedrig dotierte Halbleiter-Ätzstoppschicht (120) mit einem ersten Dotierstoff dotiert ist und mit einem zweiten Dotierstoff mit einer zum ersten Dotierstoff entgegengesetzten Dotierstoffpolarität gegendotiert ist.

13. Halbleiterwafer nach einem der Ansprüche 10 bis 12, der eine rückseitig beleuchtete BSI-Bildsensorvorrichtung (1400) oder eine Time-of-Flight-ToF-Bildsensorvorrichtung (700) oder eine Leistungshalbleitervorrichtung (1500) aufweist.

## Revendications

1. Procédé de fabrication d'un dispositif semi-conducteur, le procédé comprenant :
l'obtention d'un substrat semi-conducteur (100) comprenant
une couche de substrat semi-conducteur fortement dopée (110) ayant une densité de dopage qui est égale ou supérieure à 1×10¹⁸ cm⁻³,
une couche de dispositif semi-conducteur fortement dopée (130H), une densité de dopage de la couche de dispositif semi-conducteur fortement dopée (130H) étant égale ou supérieure à 10¹⁷ cm⁻³, ou 10¹⁸ cm⁻³, ou 5×10¹⁸ cm⁻³, et
une couche d'arrêt de gravure semi-conductrice faiblement dopée (120) en silicium disposée entre la couche de substrat semi-conducteur fortement dopée (110) et la couche de dispositif semi-conducteur fortement dopée (130H), une densité de dopage de la couche d'arrêt de gravure semi-conductrice faiblement dopée (120) étant inférieure à 10¹⁷ cm⁻³, ou 10¹⁶ cm⁻³, ou 10¹⁵ cm⁻³, la couche d'arrêt de gravure semi-conductrice faiblement dopée (120) ayant une épaisseur comprise entre 1 um et 12 µm et la couche d'arrêt de gravure semi-conductrice faiblement dopée (120) bordant la couche de dispositif semi-conducteur fortement dopée (130H) ;
le retrait de la couche de substrat semi-conducteur fortement dopée (110), le retrait comprenant une attaque chimique sélective de dopant s'arrêtant à la couche d'arrêt de gravure semi-conductrice faiblement dopée (120) ; et
l'amincissement de la couche d'arrêt de gravure semi-conductrice faiblement dopée (120) pour générer une surface exposée de la couche de dispositif semi-conducteur fortement dopée (130H).

2. Procédé selon la revendication 1, dans lequel l'amincissement de la couche d'arrêt de gravure semi-conductrice faiblement dopée (120) comprend un polissage mécanochimique, CMP, ou une attaque chimique.

3. Procédé selon la revendication 1 or 2, dans lequel le retrait de la couche de substrat semi-conducteur fortement dopée (110) comprend
le retrait partiel de la couche de substrat semi-conducteur fortement dopée (110) par meulage ; suivi par le retrait complet de la couche de substrat semi-conducteur fortement dopée résiduelle (110) par l'attaque chimique sélective de dopant.

4. Procédé selon l'une quelconque des revendications précédentes, dans lequel une variation d'épaisseur totale, TTV, de la couche d'arrêt de gravure semi-conductrice faiblement dopée (120) après retrait de la couche de substrat semi-conducteur fortement dopée (110) est égale ou inférieure à 1,0 um.

5. Procédé selon l'une quelconque des revendications précédentes, dans lequel la couche d'arrêt de gravure semi-conductrice faiblement dopée (120) est une couche épitaxiale.

6. Procédé selon l'une quelconque des revendications précédentes, dans lequel la couche d'arrêt de gravure semi-conductrice faiblement dopée (120) est dopée par un premier dopant et contre-dopée par un deuxième dopant de polarité de dopant opposée à celle du premier dopant.

7. Procédé selon l'une quelconque des revendications précédentes, dans lequel une variation d'épaisseur totale, TTV, de la couche de dispositif semi-conducteur fortement dopée après amincissement de la couche d'arrêt de gravure semi-conductrice faiblement dopée (120) est égale ou inférieure à 1,0 um.

8. Procédé selon l'une quelconque des revendications précédentes, dans lequel la couche de dispositif semi-conducteur fortement dopée (130H) est disposée sur une couche de dispositif semi-conducteur faiblement dopée (130L) et dans lequel la couche de dispositif semi-conducteur faiblement dopée (130L) et la couche de dispositif semi-conducteur fortement dopée (130H) ont une épaisseur totale égale ou inférieure à 15 µm, ou 10 µm, ou 5 um, ou 3 um, ou 2 um.

9. Procédé selon l'une quelconque des revendications précédentes, comprenant en outre :
le modelage de la couche d'arrêt de gravure semi-conductrice faiblement dopée (120) pour générer des éléments d'alignement (1550A, 1550B) qui sont configurés pour apparaître comme des marques d'alignement visibles (1550A', 1550B') dans ou sur la surface exposée de la couche de dispositif semi-conducteur fortement dopée (130H) après amincissement.

10. Tranche semi-conductrice, comprenant :
une couche de dispositif semi-conducteur faiblement dopée (130L),
une couche de dispositif semi-conducteur fortement dopée (130H) disposée sur la couche de dispositif semi-conducteur faiblement dopée (130L), une densité de dopage de la couche de dispositif semi-conducteur fortement dopée (130H) étant égale ou supérieure à 10¹⁷ cm⁻³, ou 10¹⁸ cm⁻³, ou 5×10¹⁸ cm⁻³, et
une couche d'arrêt de gravure semi-conductrice faiblement dopée (120) en silicium disposée sur la couche de dispositif semi-conducteur fortement dopée (130H), une densité de dopage de la couche d'arrêt de gravure semi-conductrice faiblement dopée (120) étant inférieure à 10¹⁷ cm⁻³, ou 10¹⁶ cm⁻³, ou 10¹⁵ cm⁻³, la couche d'arrêt de gravure semi-conductrice faiblement dopée (120) bordant la couche de dispositif semi-conducteur fortement dopée (130H), la couche d'arrêt de gravure semi-conductrice faiblement dopée (120) ayant une épaisseur comprise entre 1 um et 12 um, une surface exposée et une variation d'épaisseur totale, TTV, égale ou inférieure à 1,0 um.

11. Tranche semi-conductrice selon la revendication 10, dans laquelle l'épaisseur de la couche de dispositif semi-conducteur fortement dopée (130H) est égale ou inférieure à 15 µm,ou 10 µm,ou 5 um, ou 3 um, ou 2 um, telle que mesurée entre une première surface de la couche de dispositif semi-conducteur fortement dopée (130H) bordant la couche d'arrêt de gravure semi-conductrice faiblement dopée (120) et une deuxième surface de la couche de dispositif semi-conducteur fortement dopée (130H) bordant la couche de dispositif semi-conducteur faiblement dopée (130L).

12. Tranche semi-conductrice selon l'une quelconque des revendications 10 et 11, dans laquelle la couche d'arrêt de gravure semi-conductrice faiblement dopée (120) est dopée par un premier dopant et contre-dopée par un deuxième dopant de polarité de dopant opposée à celle du premier dopant.

13. Tranche semi-conductrice selon l'une quelconque des revendications 10 à 12, comprenant un dispositif capteur d'images rétroéclairé, BSI (1400), ou un dispositif capteur d'images à temps de vol, ToF (700), ou un dispositif semi-conducteur de puissance (1500).
